(19)

Europäisches Patentamt
European Patent Office
Office européen des brevets

(11) **EP 4 328 967 B1**

(12) **EUROPEAN PATENT SPECIFICATION**

(45) Date of publication and mention
of the grant of the patent:
**23.07.2025 Bulletin 2025/30**

(21) Application number: **23190203.2**

(22) Date of filing: **08.08.2023**

(51) International Patent Classification (IPC):
*H01L 23/525* (2006.01)    *H10D 62/832* (2025.01)
*H01L 23/62* (2006.01)    *H10D 64/27* (2025.01)
*H10D 84/00* (2025.01)

(52) Cooperative Patent Classification (CPC):
**H01L 23/5256; H10D 64/519; H10D 84/141;**
H10D 62/8325

(54) **SIC-BASED ELECTRONIC DEVICE WITH FUSE ELEMENT FOR SHORTCIRCTUITS PROTECTION, AND MANUFACTURING METHOD THEREOF**

SIC-BASIERTE ELEKTRONISCHE VORRICHTUNG MIT SICHERUNGSELEMENT FÜR KURZSCHLUSSSCHUTZ UND HERSTELLUNGSVERFAHREN DAFÜR

DISPOSITIF ÉLECTRONIQUE À BASE DE SIC AVEC ÉLÉMENT FUSIBLE POUR LA PROTECTION CONTRE LES COURTS-CIRCUITS ET SON PROCÉDÉ DE FABRICATION

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:  **26.08.2022  IT 202200017676**

(43) Date of publication of application:
**28.02.2024 Bulletin 2024/09**

(73) Proprietor: **STMicroelectronics S.r.l.**
**20864 Agrate Brianza (MB) (IT)**

(72) Inventors:
• **SCALIA, Laura Letizia**
**95037 SAN GIOVANNI LA PUNTA (CT) (IT)**

• **CAMALLERI, Cateno Marco**
**95125 CATANIA (IT)**
• **ZANETTI, Edoardo**
**95028 VALVERDE (CT) (IT)**
• **RUSSO, Alfio**
**95033 BIANCAVILLA (CT) (IT)**

(74) Representative: **Studio Torta S.p.A.**
**Via Viotti, 9**
**10121 Torino (IT)**

(56) References cited:
JP-A- S5 833 865    US-A1- 2007 210 890
US-A1- 2013 214 894    US-A1- 2019 304 907
US-B1- 6 252 292

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 328 967 B1

**Description**

The present invention relates to an electronic device, in particular a power MOSFET, provided with a protection element, and to a method for manufacturing the electronic device. In particular, the protection element is a fuse coupled to a gate strip.

Numerous scientific papers have reported good switching performances of silicon carbide (SiC) MOSFET devices. From an industrial point of view, in addition to switching performances, SiC devices also have good structural robustness which is a desirable characteristic for power systems.

During the steps of manufacturing and handling the SiC wafers, the interaction between machinery and SiC wafers may cause the release of debris, due to the high hardness of SiC. Therefore, such debris may permanently deposit on the surface of the same wafers and form local defectiveness, which may impact on the functionality of the final MOSFET device.

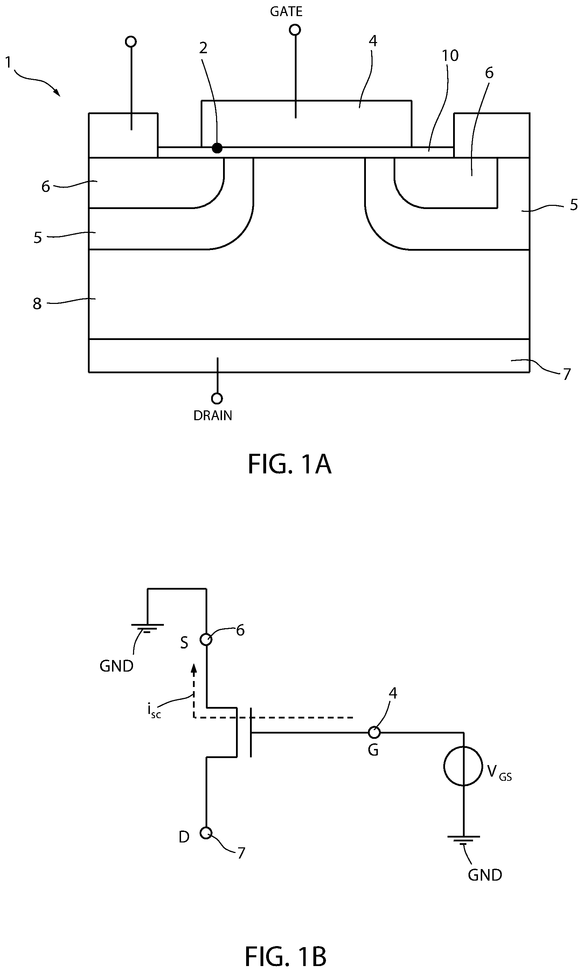

In this regard, Figure 1A illustrates, in lateral sectional view, a transistor 1, in particular a vertical-channel MOSFET transistor, comprising: a substrate 8 of SiC; a gate region 4, for example of polysilicon, arranged at a first surface of the substrate 8; a body region 5, extending into the substrate 8 at the first surface; a source region 6, extending into the body region 5 at the first surface of the substrate 8; and a drain region 7, extending at a second surface of the substrate 8, opposite to the first surface.

The transistor 1 has debris 2 interposed between the gate region 4 and the source region 6. Furthermore, a gate oxide layer 10 extends, above the source region 6, between the substrate 8 and the gate region 4; in particular, the debris 2 extends through the gate oxide layer 10 throughout the entire thickness of the latter, electrically connecting the source region 6 and the gate region 4 to each other. Therefore, the debris 2 is a punctual defect which short-circuits the gate region 4 with the source region 6.

Figure 1B is a circuit representation of the transistor 1 of Figure 1A.

In use, when the gate region 4 is biased with a biasing voltage $V_{GS}$, the debris 2 forms a conductive electrical path which causes the flow of a current $i_{SC}$ between the gate region 4 and the source region 6 (hereinafter also referred to as "short-circuit current" between the gate region 4 and the source region 6). In the presence of this current $i_{SC}$, the transistor 1 fails.

A similar problem may occur in case of imperfections resulting from the gate oxide formation process, resulting in the formation of leakage paths by direct connection or tunnel effect between the gate region 4 and the source region 6.

Similarly, defectiveness of the type described above may also, or alternatively, form between the gate region 4 and the drain region 7.

Commercially available MOSFET devices are typically formed by a plurality of transistors 1 of the type shown in Figures 1A, 1B, which are connected in parallel to each other and cooperate with each other in order to suitably manage the currents required by the specific application wherein they are used. In case of failure of even just one transistor 1, belonging to the MOSFET device, the entire MOSFET device must be rejected; this causes an increase in manufacturing costs.

Fuse or anti-fuse elements for protecting semiconductor devices are known in the prior art, for example from document US2019/0304907 A1 or from document US6,252,292 B1.

The need is therefore felt to provide a solution to the problems set forth above.

According to the present invention, an electronic device provided with a protection element and a method for manufacturing the electronic device are provided, as defined in the attached claims.

For a better understanding of the present invention, preferred embodiments thereof are now described, purely by way of non-limiting example, with reference to the attached drawings, wherein:

- Figure 1A shows, in sectional view, a MOSFET transistor according to an embodiment of known type, and having defectiveness through the gate oxide that causes a direct electrical connection between the gate terminal and the source terminal;
- Figure 1B shows a circuit diagram of the MOSFET transistor of Figure 1A;
- Figure 2 shows a circuit diagram of a MOSFET transistor provided with a protection element of a fuse type, according to an aspect of the present invention;
- Figure 3 shows, in plan view, a layout of a portion of a MOSFET device including a plurality of MOSFET transistors of Figure 2;
- Figure 4 is a lateral sectional view of the MOSFET device of Figure 3, taken along scribe line IV-IV in Figure 3, according to an embodiment of the present invention;
- Figure 5 is a lateral sectional view of the MOSFET device of Figure 3, taken along scribe line IV-IV in Figure 3, according to a further embodiment of the present invention;
- Figures 6A-6E illustrate, in lateral sectional view, manufacturing steps of the MOSFET device of Figure 4, according to an embodiment of the present invention;
- Figures 7A-7E illustrate, in lateral sectional view, manufacturing steps of the MOSFET device of Figure 5, according to a further embodiment of the present invention; and
- Figure 8 is a lateral sectional view of the MOSFET device of Figure 3, taken along scribe line IV-IV in Figure 3, according to a further embodiment of the present invention.

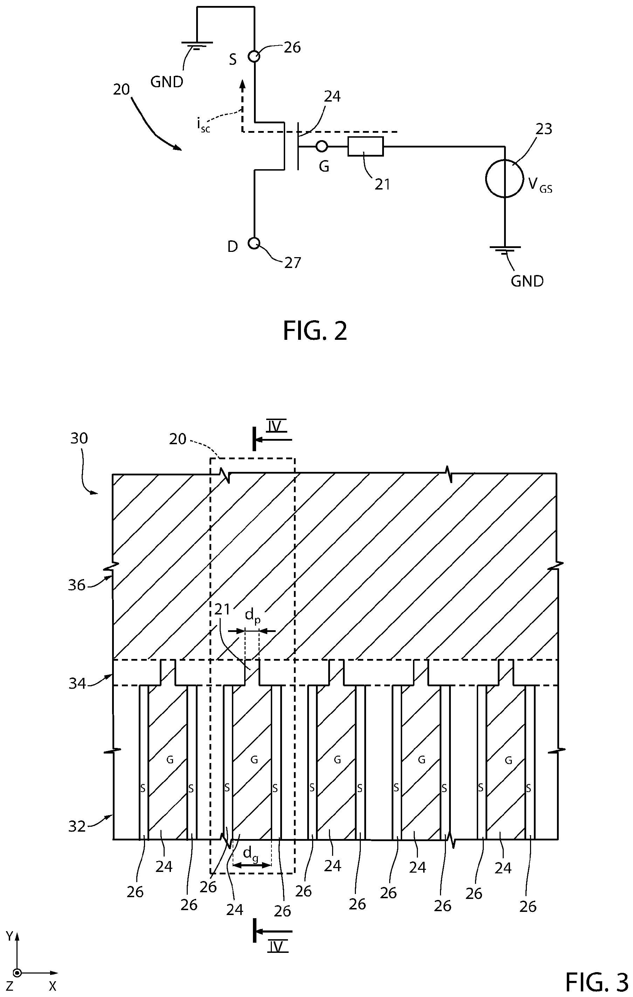

Figure 2 illustrates an equivalent circuit of a transistor 20, in particular a vertical-channel MOSFET, even more in particular a power MOSFET, according to an aspect of the present invention. The transistor 20 comprises, in a per se known manner and as briefly described with reference to Figures 1A, 1B: a gate region, or gate, 24 (forming a control terminal G) coupeable, in use, to a generator 23 of a biasing voltage $V_{GS}$; a source region or source 26 (forming a first conduction terminal S); and a drain region or drain 27 (forming a second conduction terminal D).

In particular, according to the present invention, a protection element 21 is interposed between the gate region 24 and the generator 23. More in particular, the protection element 21 is a fuse configured to interrupt the electrical connection between the generator 23 and the gate region 24 in the presence of the short-circuit current $i_{SC}$ (illustrated in Figure 1B and described with reference to this Figure), caused by the presence of the defectiveness, or punctual defect, 2 (the latter exemplarily represented in Figure 1A, as previously described).

A MOSFET device according to the present invention is formed by a plurality (two or more) of transistors 20 of the type shown in Figure 2, connected to each other in parallel. In case of failure of a transistor 20 that generates a flow of short-circuit current through one or more fuses 21 higher than what is expected during the normal operativeness of the device, the respective fuse 21 melts/blows, causing the interruption of the flow of short-circuit current $i_{SC}$ between the generator 23 and the source region 26 through the gate region 24 and the punctual defect 2.

Figure 3 shows, in a triaxial Cartesian reference system X, Y, Z, a portion of a MOSFET device 30 according to an embodiment of the present invention; in particular, the MOSFET device 30 is shown in an XY-plane top view and only the elements essential to the understanding of the present embodiment are shown.

The MOSFET device 30 comprises an active-area region 32, a protection region 34, and a connection region 36. The protection region 34 is interposed between the active-area region 32 and the connection region 36.

In detail, the active-area region 32 includes a plurality of gate regions 24 and a plurality of source regions 26, of the strip type, each extending along a respective main direction, parallel to the Y axis, in a per se known manner.

The connection region 36 is a conductive path (e.g., having a ring-like shape) that connects all the gate regions 24 to a common gate terminal.

Each gate region 24, in particular of polysilicon or metal, has a width $d_G$, measured along the X axis, for example comprised between 1.5 μm and 4 μm.

The protection region 34 includes a plurality of protection elements 21 (also referred to as "fuses"), each of which being in electrical connection with a respective gate region 24. In particular, in the embodiment of Figure 3, each fuse 21 is in structural and electrical continuity with the respective gate region 24. In other words, the fuse 21 and the respective gate region 24 form a monolithic structure. According to an aspect of the present invention, both the gate region 24 and the fuse 21 are of conductive polysilicon or of metal material. In a further embodiment, each fuse 21 is of a different material with respect to the material of the gate region 24 whereto it is coupled (e.g., the gate region 24 is of polysilicon and the fuse 21 is of metal).

Each fuse 21 has, in one embodiment, a substantially parallelepipedal shape with width $d_P$, measured along the X axis, smaller than the respective width $d_G$ of the gate region 24 whereto it is coupled. The width $d_P$ is, for example, comprised between 1 μm and 2.5 μm.

Alternatively to what has been said, in a further embodiment, each fuse 21 has dimensions (in particular width $d_P$) equal to the dimensions (in particular width $d_G$) of the gate region 24 whereto it is coupled. In this case, the short-circuits protection (i.e., the ability of the fuse 21 to melt/blow before the gate region 24) is obtained by suitably selecting the material of the fuse 21 (material having a melting point for lower temperatures with respect to the material of the gate region 24).

The connection region 36 comprises a conductive portion 25 which extends coplanar with the fuse 21 and in continuity with the fuse 21. In particular, the conductive portion 25 is of polysilicon or metal, and is electrically coupled to each fuse 21 and, through the latter, to each gate region 24; above the conductive portion 25, and in electrical contact with the conductive portion 25, a metal layer 63 extends which forms a pad configured to be electrically coupled to the generator 23, in a per se known manner.

The conductive portion 25 may have any shape, for example it extends to form a ring that follows the shape and the extension of the region 36 of Figure 3. Alternatively, a plurality of conductive portions 25 may be present which extend in the form of a strip, each of which being electrically in contact with the metallization 63.

In one embodiment, each fuse 21 is in structural and electrical continuity with the respective conductive portion 25 in the connection region 36. In other words, the conductive portion 25, the respective fuse 21 coupled thereto and the respective gate region 24 coupled to this fuse 21 form a monolithic structure. In a different embodiment, each fuse 21 is of a material different from the material of the gate region 24 and the conductive region 25 whereto it is coupled (e.g., the gate region 24 and the conductive region 25 are of polysilicon, and the fuse 21 is of metal).

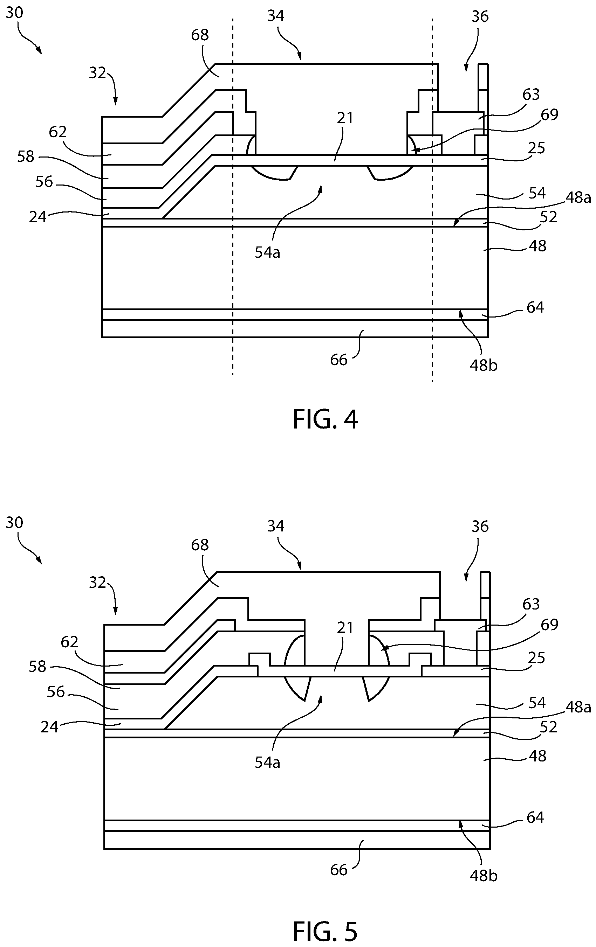

Figure 4 shows a cross-sectional view of the MOSFET device 30 of Figure 3; in particular, Figure 4 is taken along scribe line IV-IV of Figure 3.

In detail, the transistor 20 comprises a substrate 48, in particular of SiC, having a first and a second face 48a, 48b opposite to each other. In particular, in the present embodiment, the term "substrate" means a structural element which may comprise (but does not necessarily comprise) one or more epitaxial layers grown on a starting substrate.

An insulating layer 52 (in particular, a gate oxide), for example of deposited Silicon Oxide (SiO2), with thickness, measured along the Z axis, comprised between 30 nm and 60 nm, extends on the first face 48a.

The gate region (strip) 24 extends at the active-area region 32, on the insulating layer 52.

A field plate oxide layer 54, in particular of TEOS, extends at the protection region 34 and at the connection region 36, on the insulating layer 52. The field plate oxide layer 54 has a thickness, measured along the Z axis, at the protection region 34, comprised between 0.5 $\mu$m and 2.5 $\mu$m. The field-plate-oxide layer 54 has a thickness, measured along the Z axis, at the connection region 36, comprised between 1 $\mu$m and 2 $\mu$m.

The fuse 21, of thickness h, measured along the Z axis, comprised between 5 $\mu$m and 15 $\mu$m extends at the protection region 34, on the field-plate-oxide layer 54. In one embodiment, the fuse 21 has a XZ-plane section (i.e., base area of the fuse 21) comprised between 0.5 and 1.5 $\mu$m$^2$.

According to an embodiment, as said, the fuse 21 is in electrical and structural continuity with the gate region 24. Furthermore, the fuse 21 is at least in part in electrical and structural continuity with the conductive region 25.

A further insulating layer 56 extends on the gate region 24 and on the fuse 21, at the active region 32 and at the protection region 34, respectively. The insulating layer 56 also extends at the connection region 36, above the conductive strip which extends in continuity with the fuse 21. The further insulating layer 56 is, in particular, of TEOS and has a thickness, measured along the Z axis, comprised between 500 nm and 900 nm.

A metallization layer 58, for example of Al/Si/Cu and of thickness, measured along the Z axis, comprised between 2.5 $\mu$m and 7 $\mu$m, extends at the active region 32, on the further insulating layer 56. The metallization layer 58 forms the first conduction terminal S (source) of the transistor 2 of Figure 2.

A passivation layer 62, for example of SiN, extends at the active region 32, the protection region 34 and the connection region 36, in particular respectively on the metallization layer 58, and on the further insulating layer 56.

A metal layer 63 extends, at the connection region 36, through the insulating layer 56 and the passivation layer 62, up to electrically contacting the conductive portion 25. The metal layer 63 (and at least in part also the underlying conductive portion 25) forms the aforementioned gate ring and is therefore in electrical contact with the gate regions 24 through the respective fuses 21.

An interface layer 64, in particular of nickel silicide, extends on the second face 48b. A metallization layer 66, for example of Ti/Ni/Au, extends on the interface layer 64. The metallization layer 66 forms the second conduction terminal D (drain) of the transistor 20 of Figure 2.

According to the present invention, at the protection region 34, i.e. at the fuse 21, a buried cavity 69 is present which extends completely through the insulating layer 56 (above the fuse 21 along Z) and in part through the field-plate-oxide layer 54 (below the fuse 21 along Z). The fuse 21 is supported, in the cavity 69, by a portion 54a of the field-plate-oxide layer 54 which protrudes within the cavity 69. The cavity 69 is closed at the top by a polymeric layer 68, in particular insulating (e.g., of Polyimide, PI, or Polyimide-Iso-IndroQuinazalinedione, PIQ). The insulating polymeric layer 68 extends above the passivation layer 62 and, at the protection region 34, extends into an opening made through the passivation layer 62 and the insulating layer 56, up to reaching the cavity 69 and the fuse 21. As better illustrated hereinbelow, the formation of the insulating polymeric layer 68 is such that the cavity 69 is not completely filled by the insulating polymeric layer 68, but is closed at the top by the insulating polymeric layer 68.

Under normal operating conditions, i.e. in the absence of defectiveness of the type shown 1A, there are no leakage currents between the gate region 24 and the source region 26 or, in any case, possible leakage currents are of the order of 10 nA (for gate biasing voltages $V_{GS}$ of the order of ± 20 V), and therefore negligible. Conversely, in the presence of the aforementioned defectiveness, a current (i.e., the short-circuit current $i_{SC}$) of the order of mA or slightly less (e.g., greater than 0.8 mA) is observed.

The Applicant has verified that when, during use, the short-circuit current $i_{SC}$, in particular equal to about 1 mA, flows through the fuse 21 for a time t equal to about 1 ms, a temperature variation $\Delta T$ of the order of $10^4$ K, develops according to the formula:

$$\Delta T = \frac{\rho i_{SC}{}^2 t}{c D h^2 d_P{}^2}$$

where $\rho$ is the electrical resistivity of the fuse 21 (in the case of polysilicon equal to $10e^{-4}$ $\Omega \cdot cm$), c is the specific heat (in the case of polysilicon equal to 700 $J/kg \cdot keV$), D is the density of the material of the fuse 21 (in the case of polysilicon equal to 2330 kg/m$^3$), h is the thickness along the Z axis of the fuse 21 and $d_P$ is the width along the X axis of the fuse 21.

The Applicant has also verified that such a temperature variation $\Delta T$ in the time interval considered causes the fuse 21 to melt/blow, resulting in the insulation of the transistor 20 from the generator 23 (Figure 2).

The fuse 21 is designed in such a way as to interrupt the electrical connection between the connection region 36 (connected in use to the generator 23) and the gate region 24 in the presence of the short-circuit current $i_{SC}$ between the gate region 24 and the source region 26, whose value depends on the biasing voltage $V_{GS}$ and which is, in any case, greater than the leakage current observable under normal operating conditions. In particular, the fuse 21 is designed in such a way as to change physical state (e.g., from solid to melted or from solid to gaseous) in the presence of the short-circuit current $i_{SC}$.

In general, therefore, the fuse 21 is designed so as to interrupt the electrical connection between the connection region 36 and the gate region 24 (e.g., by changing physical state) in the presence of a current greater than a critical threshold equal to at least one order of magnitude higher with respect to the leakage current under normal operating conditions (e.g., critical threshold equal to or greater than 50 nA).

The presence of the buried cavity 69 around the fuse 21 or, in other words, the formation of the fuse 21 at least in part within the buried cavity 69, allows the material in melted state or gaseous state of the fuse 21 to flow and be gathered within the buried cavity 69. In this manner, possible problems linked to a breakdown of the device 30 caused by the local increase in pressure following the change of state of the material of the fuse 21 are overcome.

Figure 5 shows a cross-sectional view, taken along scribe line IV-IV, of an embodiment of the MOSFET device 30 of Figure 3 alternative to the embodiment of Figure 4. Elements corresponding to those shown in Figure 4 are indicated in Figure 5 with the same reference numbers and will not be further described.

In the embodiment of Figure 5, each fuse 21 is in electrical continuity with the respective gate region 24 and with the conductive portion 25 extending into the connection region 36; however, in this case the gate region 24 and the conductive portion 25 do not form a monolithic body with the fuse 21. The fuse 21 is here formed by a material different from the material of the gate region 24 and the conductive portion 25 (e.g., the latter are of polysilicon and the fuse 21 is of metal).

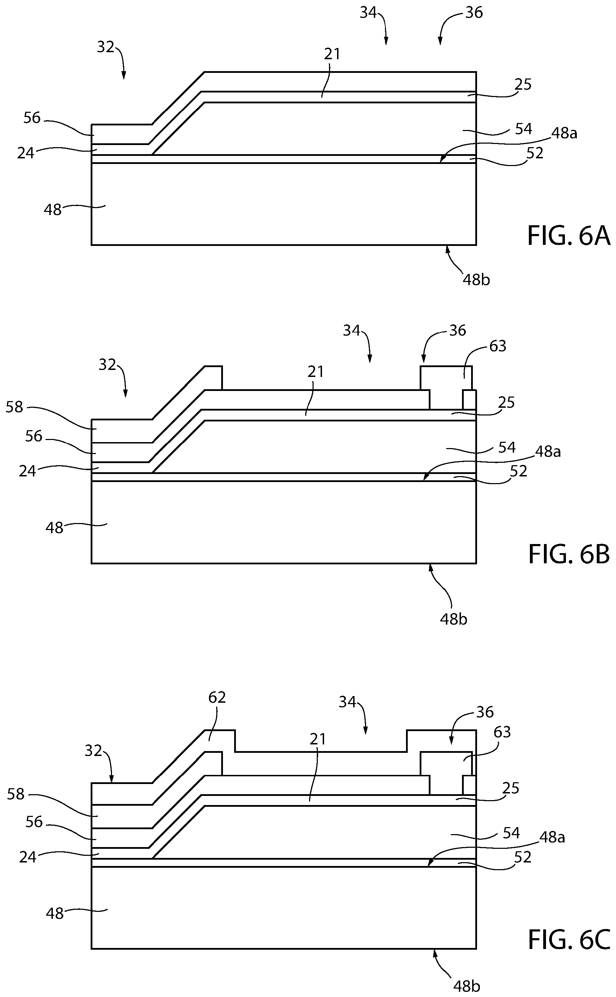

Figures 6A-6E show manufacturing steps of the MOSFET device 30 of Figure 4, according to an embodiment of the present invention.

With reference to Figure 6A, the substrate 48, for example of Silicon Carbide, SiC, is provided.

Then, on the front side 48a, the oxide layer 52, for example $SiO_2$, is formed by CVD deposition and/or thermal oxidation. Subsequently, the field-plate-oxide layer 54 is formed on the oxide layer 52; more in particular, the field-plate-oxide layer 54 is formed at the protection region 34 intended to accommodate the fuse 21 and at the connection region 36 intended to accommodate the gate ring. To this end, it is performed a step of depositing TEOS and subsequently patterning the same to remove the field-plate-oxide layer 54 from the active-area region 32. In this manner, at the active-area region 32, the field-plate-oxide layer 54 is removed up to reaching the underlying oxide layer 52.

Then, a conductive layer, e.g. of polysilicon, is formed over the oxide layer 52 in the active-area region 32, and over the field-plate-oxide layer 54 in the protection 34 and connection regions 36; this conductive layer is then patterned (e.g., by lithography and etching steps) to form the conductive strips relating to the gate regions 24, the fuses 21 and the conductive portions 25, in the respective regions 32, 34 and 36.

Then, the insulating layer 56 is formed by depositing TEOS on the gate regions 24, fuses 21 and conductive portions 25.

With reference to Figure 6B, the insulating layer 56 is opened at the connection region 36 up to reaching the conductive portions 25; conductive material, in particular metal, is then deposited to form the metallizations 58 and 63. The metallizations 58 and 63 do not extend at the protection region 34.

Then, Figure 6C, the method proceeds with the formation of the passivation layer 62, depositing SiN. The passivation layer extends on the metallizations 58 and 63 and on the insulating layer 56 where the latter is exposed (protection region 34).

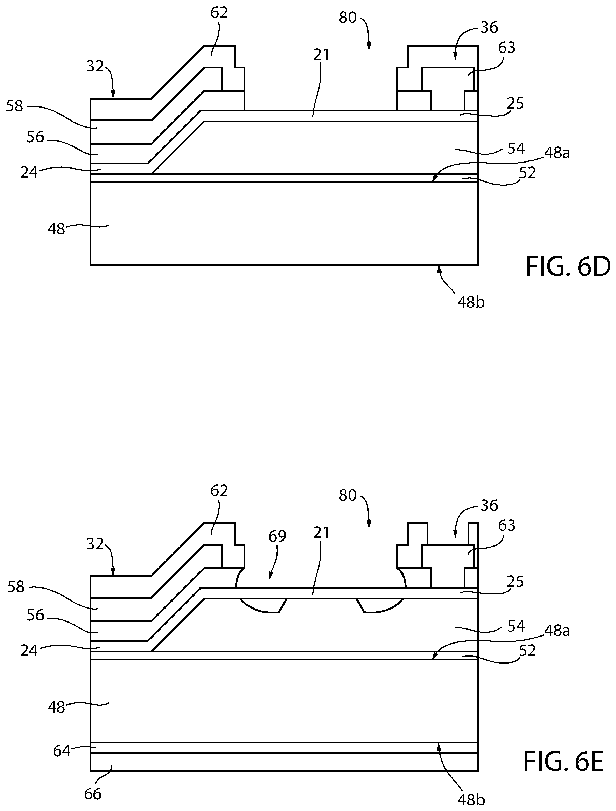

Then, Figure 6D, a step of etching the passivation layer 62 is performed at the protection region 34 (i.e. between the metallizations 58 and 63), up to reaching the underlying insulating layer 56. The etching of the passivation layer 62 is performed where it is desired to form the fuses 21 and, in particular, the buried cavities 69 accommodating the fuses 21. Where the buried cavities 69 are not formed, the passivation layer 62 is not removed.

An opening 80 is thus formed wherethrough, Figure 6E, the material of the insulating layer 56 and field-plate-oxide layer 54 may be removed, by isotropic etching, to form the buried cavity 69. Since the material of the insulating layer 56 and field-plate-oxide layer 54 is the same, a single etching, using for example HF-(hydrofluoric acid) based chemistries, is sufficient to form the cavity 69. Since, as illustrated in Figure 3, the gate regions 24 and the fuses 21 extend in the form of a strip, forming the opening 80 having a dimension (along the Y axis) greater than the corresponding width of the relative fuse 21, the etching of the step of Figure 6E extends to the portions of the field-plate-oxide layer 54 lateral with respect to the strip of fuse 21, removing in part the material below the fuse 21. By adjusting the etching by time, a portion of the field-plate-oxide layer 54 may be maintained below and vertically aligned to the fuse 21, in physical support of the latter, (i.e. the portion 54a previously described).

A step of forming the insulating polymeric layer 68, as said of Patterned Polyimide, PI, or Polyimide-Iso-IndroQuinazalinedione, PIQ, is then performed. The polymeric material PI or PIQ is deposited in a per se known manner.

The polymeric material PI or PIQ is known to be a material that may be deposited by spinning technique. When it is dispensed in the liquid phase on the rotating wafer, it forms a thin film which is then made denser, if necessary, with thermal treatments. Considering the planarizing and viscosity properties of the polymeric material PI or PIQ, it does not completely penetrate within the cavity that accommodates the fuse, but closes it at the top.

The device 30 of Figure 4 is thus obtained.

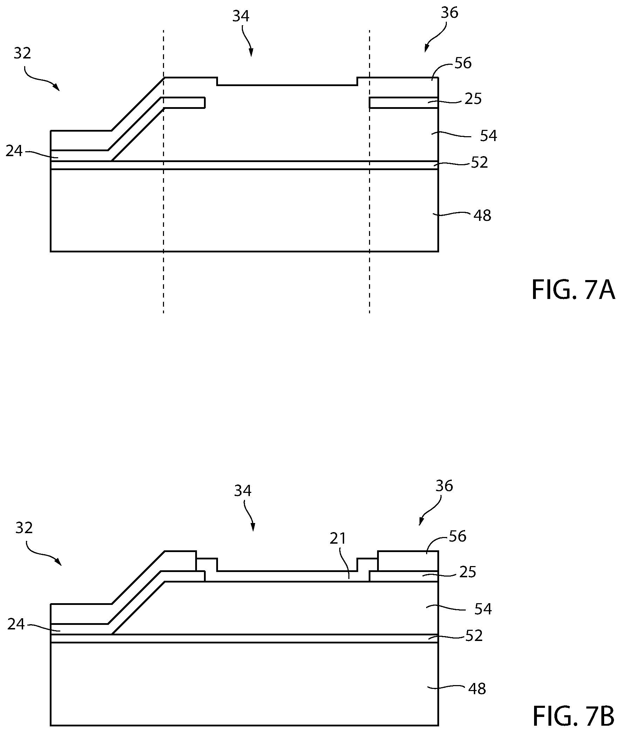

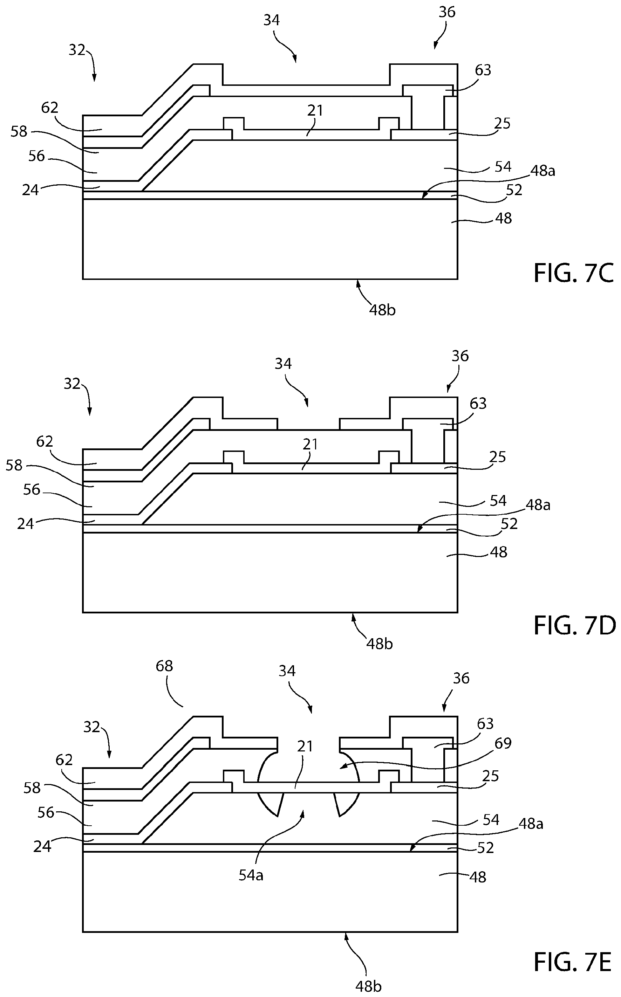

Figures 7A-7E show manufacturing steps of the MOSFET device 30 of Figure 5, according to an embodiment of the present invention.

With reference to Figure 7A, the substrate 48, for example of Silicon Carbide, SiC, is provided.

Then, the oxide layer 52, for example $SiO_2$, is formed on the front side 48a as described with reference to Figure 6A.

Subsequently, the field-plate-oxide layer 54 is formed on the oxide layer 52; more particularly, the field-plate-oxide layer 54 is formed at the protection region 34 intended to accommodate the fuse 21 and at the connection region 36 intended to accommodate the gate ring. To this end, it is performed a step of depositing TEOS and subsequently patterning the same to remove the field-plate-oxide layer 54 from the active-area region 32. In this manner, at the active-area region 32, the field-plate-oxide layer 54 is removed up to reaching the underlying oxide layer 52.

Then, a conductive layer, e.g. of polysilicon, is formed over the oxide layer 52 in the active-area region 32, and over the field-plate-oxide layer 54 in the protection 34 and connection regions 36; this conductive layer is then patterned (e.g., by lithography and etching steps) to form the conductive strips relating to the gate regions 24 and the conductive portions 25, in the respective regions 32 and 36. The polysilicon conductive layer is removed at the protection region 34, i.e. it is removed where the formation of the fuses 21 is foreseen.

Then, the insulating layer 56 is formed by depositing TEOS on the gate regions 24 and conductive portions 25, and over the field-plate-oxide layer 54 in the protection region 34 where the polysilicon layer is missing.

With reference to Figure 7B, the insulating layer 56 is removed in the protection region 34, between the gate regions 24 and the conductive portions 25, exposing respective terminal portions of the gate regions 24 and of the conductive portions 25. Then a step of depositing and patterning conductive material (such as for example Ti, or TiN, or Al, or Ni), more particularly metal, is performed. The deposition of this conductive material is performed in particular on the terminal portions of the gate regions 24 and of the conductive portions 25 exposed, and on the field-plate-oxide layer 54 comprised between the gate regions 24 and the conductive portions 25. The fuses 21 are thus formed.

The method then proceeds with steps similar to those of Figures 6B-6E, and therefore not further described.

The device 30 of Figure 5 is thus obtained.

From an examination of the characteristics of the invention made according to the present invention, the advantages that it affords are evident.

In particular, the fuses are implemented without modifications to the passivating cover, while the melted/-gaseous material of the fuse after breaking has sufficient space to drain without negatively affecting the structure of the device.

Furthermore, in MOSFET devices formed by a plurality of transistors, connected in parallel to each other and cooperating with each other in order to suitably manage the currents required by the specific application wherein they are used, in case of failure of even just one transistor, belonging to the MOSFET device, the functionality of the entire MOSFET device may be restored by disconnecting the single faulty transistor, maintaining good electrical insulation characteristics and having a fractional loss on the current flow of the device.

Furthermore, in case of degradation of the insulation between the gate terminal and the source terminal of one or more transistors of the MOSFET device due to a leakage current greater than 0.8 mA, in use, the fuse relating to such one or more degraded transistors would melt, automatically segregating the degraded transistor.

Finally, it is clear that modifications and variations may be made to what has been described and illustrated herein, without thereby departing from the scope of the present invention, as defined in the attached claims.

For example, the present invention may be applied to devices with a substrate of a material other than SiC, for example Si, GaN (gallium nitride) or glass or other material.

Furthermore, the present invention finds applications in devices other than MOSFETs, for example GaN power devices, LDMOS ("Laterally Diffused MOS"), VMOS ("Vertical MOS"), DMOS ("Diffused MOS"), CMOS ("Complementary MOS"), or other integrated devices provided with a control terminal and at least one conduction terminal.

Furthermore, the device 30 may include one or more horizontal-channel MOSFET transistors.

Furthermore, the device 30 may be formed by a single transistor 20. In this case, the melting/blowing of the fuse 21 interrupts the operation of the entire device 30. This embodiment may be useful in the event that the device 30 is integrated in a complex electronic system and is not vital for the operation of the electronic system (for example, in the presence of redundancy), but wherein the failure of this device 30 could compromise the operation of other elements of the electronic system.

In addition, in the embodiment of Figures 4 and 5, the fuse 21 may be of a material different from metal or the material of the gate region 24 and/or the connection region 36, for example of a conductive polymer, with electrical resistivity lower than $\Omega \cdot cm$.

Furthermore, the fuse 21 may have a geometrical shape different from the parallelepipedal shape, such as, for example, a cylindrical or generically polyhedral shape.

According to a further embodiment, the protection element 21 is configured to interrupt the electrical connection between the connection region 36 and the gate region 24 in the absence of a change of physical state, but by breaking (direct or mediated by the presence of a further element) of the protection element 21 in the presence of the short-circuit current $i_{SC}$.

Furthermore, it is evident that the cavity 69 may have a different shape from what has been shown, depending on the type of etching used to form the cavity.

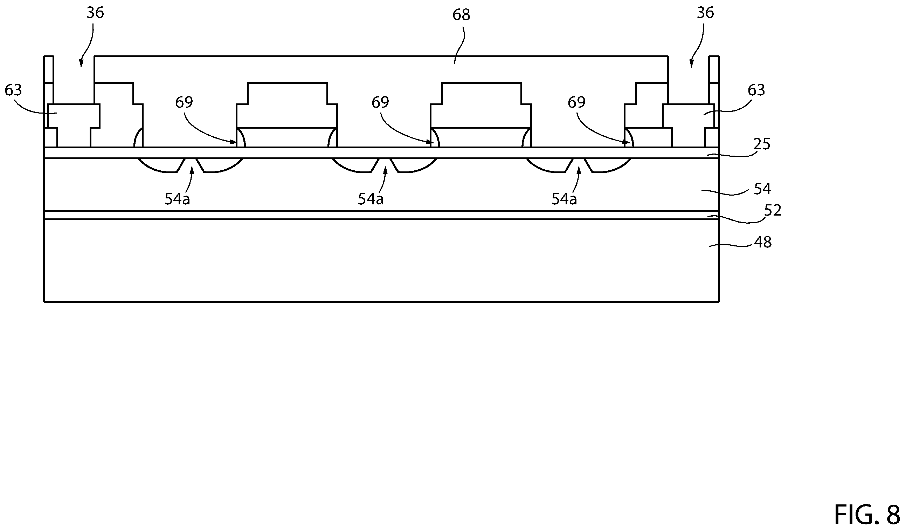

In a further embodiment, a plurality of cavities 69 for each fuse 21 are present, arranged aligned to each other along the main extension of the fuse 21 (i.e., along the Y direction). Figure 8 shows, by way of example, this embodiment. As may be noted, the cavities 69 extend in series with each other along Y and are separated from each other.

**Claims**

1. An electronic device (20; 30) comprising:

   a solid body (48), in particular including Silicon Carbide;
   a gate terminal (24), extending into the solid body (48);
   a conductive path (36), extending at a first side of the solid body (48), configured to be electrically coupeable to a generator (23) of a biasing voltage ($V_{GS}$) of said gate terminal (24);
   a protection element (21) of a solid-state material, coupled to the gate terminal (24) and to the conductive path (36), the protection element (21) forming an electrical connection between the gate terminal (24) and the conductive path (36), and being configured to go from the solid state to a melted or gaseous state, interrupting said electrical connection, in response to a leakage current ($i_{SC}$) through said protection element (21) greater than a critical threshold,
   **characterized in that** it further comprises a buried cavity (69) in the solid body (48) accommodating, at least in part, said protection element (21).

2. The electronic device according to claim 1, wherein the buried cavity (69) is configured to contain material in melted or gaseous state of the protection element (21).

3. The electronic device according to any of the preceding claims, wherein the buried cavity (69) accommodates a support for supporting, at least in part, said protection element (21).

4. The electronic device according to any of the preceding claims, wherein the protection element (21) is a fuse.

5. The electronic device according to any of the preceding claims, wherein the protection element (21) is of a material having an electrical resistivity lower than 10 $\Omega \cdot cm$, chosen from among polysilicon, metal or conductive polymer.

6. The electronic device according to any of the preceding claims, wherein the protection element (21), the gate terminal (24) and the conductive path (36) form a monolithic structure.

7. The electronic device according to any of the preceding claims, further comprising a covering layer (68), in particular of polymeric material, which closes said buried cavity (69) at the top.

8. The electronic device according to claim 7, wherein the covering layer (68) extends in part into the buried cavity by physically contacting the protection element (21).

9. The electronic device according to claim 7 or 8, wherein the covering layer (68) is of Polyimide, PI, or Polyimide-Iso-IndroQuinazalinedione, PIQ.

10. The electronic device according to any of claims 7-9, wherein the covering layer (68) has a lower mechanical resistance with respect to the mechanical resistance of the solid body.

11. The electronic device according to any of the preceding claims, wherein the protection element (21) is of metal and extends in part on the gate terminal (24) and on the conductive path (36), said gate terminal (24) and said conductive path (36) being electrically coupled to each other exclusively by the protection element (21).

12. The electronic device according to any of the preceding claims, wherein said solid body includes Silicon Carbide, siC, and said device is a vertical conduction MOSFET and further comprises a source terminal (26), extending into the solid body (48) laterally to the gate terminal at a first side, of the solid body (48), and a drain terminal (66) extending at a second side, opposite to the first side, of the solid body (48).

13. The electronic device according to any of the preceding claims, wherein the gate terminal (24) is of strip type.

14. A method for manufacturing an electronic device (20; 30), comprising the steps of:

   forming a gate terminal (24) in a solid body (48);

forming a conductive path (36) configured to be electrically coupeable to a generator (23) of a biasing voltage ($V_{GS}$) of the gate terminal; forming a protection element (21) of a solid-state material, coupled to the gate terminal (24) and the conductive path (36), the protection element (21) forming an electrical connection between the gate terminal (24) and the conductive path (36), and being configured to go from the solid state to a melted or gaseous state, interrupting said electrical connection, in response to a leakage current ($i_{SC}$) through said protection element (21) greater than a critical threshold, **characterized in that** it further comprises the step of forming a buried cavity (69) in the solid body (48) accommodating, at least in part, said protection element (21).

**Patentansprüche**

1. Elektronische Vorrichtung (20; 30), umfassend:

   einen festen Körper (48), der insbesondere Siliciumcarbid beinhaltet;
   einen Gate-Anschluss (24), der sich in den festen Körper (48) erstreckt;
   einen leitfähigen Pfad (36), der sich auf einer ersten Seite des festen Körpers (48) erstreckt, der so ausgestaltet ist, dass er elektrisch mit einem Generator (23) einer Vorspannung ($V_{GS}$) des Gate-Anschlusses (24) gekoppelt werden kann;
   ein Schutzelement (21) aus einem Feststoffmaterial, das mit dem Gate-Anschluss (24) und mit dem leitfähigen Pfad (36) gekoppelt ist, wobei das Schutzelement (21) eine elektrische Verbindung zwischen dem Gate-Anschluss (24) und dem leitfähigen Pfad (36) bildet und so ausgestaltet ist, dass es in Reaktion auf einen Leckstrom ($i_{SC}$) durch das Schutzelement (21), der größer ist als eine kritische Schwelle, vom Feststoffzustand in einen geschmolzenen oder gasförmigen Zustand übergeht, wodurch die elektrische Verbindung unterbrochen wird, **dadurch gekennzeichnet, dass** sie weiter einen vergrabenen Hohlraum (69) in dem festen Körper (48) umfasst, der mindestens teilweise das Schutzelement (21) beherbergt.

2. Elektronische Vorrichtung nach Anspruch 1, wobei der vergrabene Hohlraum (69) so ausgestaltet ist, dass er Material im geschmolzenen oder gasförmigen Zustand des Schutzelements (21) enthalten kann.

3. Elektronische Vorrichtung nach einem der vorstehenden Ansprüche, wobei der vergrabene Hohlraum (69) eine Stütze zum mindestens teilweisen Abstützen des Schutzelements (21) beherbergt.

4. Elektronische Vorrichtung nach einem der vorstehenden Ansprüche, wobei das Schutzelement (21) eine Sicherung ist.

5. Elektronische Vorrichtung nach einem der vorstehenden Ansprüche, wobei das Schutzelement (21) aus einem Material ist, das einen spezifischen elektrischen Widerstand von weniger als 10 $\Omega\cdot$cm aufweist, ausgewählt aus Polysilicium, Metall oder leitfähigem Polymer.

6. Elektronische Vorrichtung nach einem der vorstehenden Ansprüche, wobei das Schutzelement (21), der Gate-Anschluss (24) und der leitfähige Pfad (36) eine monolithische Struktur bilden.

7. Elektronische Vorrichtung nach einem der vorstehenden Ansprüche, die weiter eine Deckschicht (68), insbesondere aus Polymermaterial, umfasst, die den vergrabenen Hohlraum (69) an der Oberseite verschließt.

8. Elektronische Vorrichtung nach Anspruch 7, wobei sich die Deckschicht (68) teilweise in den vergrabenen Hohlraum erstreckt, indem sie das Schutzelement (21) physisch kontaktiert.

9. Elektronische Vorrichtung nach Anspruch 7 oder 8, wobei die Deckschicht (68) aus Polyimid, PI, oder Polyimid-Iso-Indro-Quinazalindion, PIQ ist.

10. Elektronische Vorrichtung nach einem der Ansprüche 7-9, wobei die Deckschicht (68) in Bezug auf die mechanische Festigkeit des festen Körpers eine niedrigere mechanische Festigkeit aufweist.

11. Elektronische Vorrichtung nach einem der vorstehenden Ansprüche, wobei das Schutzelement (21) aus Metall ist und sich teilweise auf dem Gate-Anschluss (24) und auf dem leitfähigen Pfad (36) erstreckt, wobei der Gate-Anschluss (24) und der leitfähige Pfad (36) ausschließlich durch das Schutzelement (21) elektrisch miteinander gekoppelt sind.

12. Elektronische Vorrichtung nach einem der vorstehenden Ansprüche, wobei der feste Körper Siliciumcarbid, siC, beinhaltet und die Vorrichtung ein vertikal leitender MOSFET ist und weiter einen Source-Anschluss (26), der sich in den festen Körper (48) seitlich zum Gate-Anschluss auf einer ersten Seite des festen Körpers (48) erstreckt, und einen Drain-Anschluss (66), der sich auf einer zweiten, der ersten Seite gegenüberliegenden Seite des festen Körpers (48) erstreckt, umfasst.

**13.** Elektronische Vorrichtung nach einem der vorstehenden Ansprüche, wobei der Gate-Anschluss (24) vom Streifentyp ist.

**14.** Verfahren zum Herstellen einer elektronischen Vorrichtung (20; 30), das die folgenden Schritte umfasst:

Bilden eines Gate-Anschlusses (24) in einem festen Körper (48);
Bilden eines leitfähigen Pfads (36), der so ausgestaltet ist, dass er elektrisch mit einem Generator (23) einer Vorspannung ($V_{GS}$) des Gate-Anschlusses gekoppelt werden kann;
Bilden eines Schutzelements (21) aus einem Feststoffmaterial, das mit dem Gate-Anschluss (24) und dem leitfähigen Pfad (36) gekoppelt ist, wobei das Schutzelement (21) eine elektrische Verbindung zwischen dem Gate-Anschluss (24) und dem leitfähigen Pfad (36) bildet und so ausgestaltet ist, dass es in Reaktion auf einen Leckstrom ($i_{SC}$) durch das Schutzelement (21), der größer ist als eine kritische Schwelle, vom Feststoffzustand in einen geschmolzenen oder gasförmigen Zustand übergeht, wodurch die elektrische Verbindung unterbrochen wird, **dadurch gekennzeichnet, dass** es weiter den Schritt des Bildens eines vergrabenen Hohlraums (69) in dem festen Körper (48), der mindestens teilweise das Schutzelement (21) beherbergt, umfasst.

**Revendications**

**1.** Dispositif électronique (20 ; 30) comprenant :

un corps solide (48), en particulier comprenant du carbure de silicium ;
une borne de grille (24) s'étendant dans le corps solide (48) ;
un chemin conducteur (36), s'étendant sur un premier côté du corps solide (48), configuré pour pouvoir être couplé électriquement à un générateur (23) d'une tension de polarisation ($V_{GS}$) de ladite borne de grille (24) ;
un élément de protection (21) en matériau à l'état solide, couplé à la borne de grille (24) et au chemin conducteur (36), l'élément de protection (21) formant une connexion électrique entre la borne de grille (24) et le chemin conducteur (36), et étant configuré pour passer de l'état solide à un état fondu ou gazeux, interrompant ladite connexion électrique, en réponse à un courant de fuite ($i_{SC}$) traversant ledit élément de protection (21) supérieur à seuil critique, **caractérisé en ce qu'**il comprend en outre un cavité enfouie (69) dans le corps solide (48) contenant, au moins en partie, ledit élément de protection (21).

**2.** Dispositif électronique selon la revendication 1, dans lequel la cavité enfouie (69) est configurée pour contenir le matériau à l'état fondu ou gazeux de l'élément de protection (21).

**3.** Dispositif électronique selon l'une quelconque des revendications précédentes, dans lequel la cavité enfouie (69) contient un support destiné à supporter, au moins en partie, ledit élément de protection (21).

**4.** Dispositif électronique selon l'une quelconque des revendications précédentes, dans lequel l'élément de protection (21) est un fusible.

**5.** Dispositif électronique selon l'une quelconque des revendications précédentes, dans lequel l'élément de protection (21) est fait d'un matériau ayant une résistivité électrique inférieure à 10 $\Omega \cdot cm$, choisi parmi le polysilicium, un métal ou un polymère conducteur.

**6.** Dispositif électronique selon l'une quelconque des revendications précédentes, dans lequel l'élément de protection (21), la borne de grille (24) et le chemin conducteur (36) forment une structure monolithique.

**7.** Dispositif électronique selon l'une quelconque des revendications précédentes, comprenant en outre une couche de couverture (68), en particulier en matériau polymère, qui ferme ladite cavité enfouie (69) en son sommet.

**8.** Dispositif électronique selon la revendication 7, dans lequel la couche de couverture (68) s'étend en partie dans la cavité enfouie en étant en contact physique avec l'élément de protection (21).

**9.** Dispositif électronique selon la revendication 7 ou 8, dans lequel la couche de couverture (68) est faite de polyimide, PI, ou de polyimide iso-indroquinazalinedione, PIQ.

**10.** Dispositif électronique selon l'une quelconque des revendications 7 à 9, dans lequel la couche de couverture (68) a une résistance mécanique inférieure à la résistance mécanique du corps solide.

**11.** Dispositif électronique selon l'une quelconque des revendications précédentes, dans lequel l'élément de protection (21) est en métal et s'étend en partie sur la borne de grille (24) et sur le chemin conducteur (36), ladite borne de grille (24) et ledit chemin conducteur (36) étant couplés électriquement l'un à l'autre exclusivement par l'élément de protection (21).

**12.** Dispositif électronique selon l'une quelconque des revendications précédentes, dans lequel ledit corps solide comprend du carbure de silicium, SiC, et ledit dispositif est un MOSFET à conduction verticale et comprend en outre une borne de source (26), s'étendant dans le corps solide (48) latéralement par rapport à la borne de grille sur un premier côté du corps solide (48), et une borne de drain (66) s'étendant sur un deuxième côté, opposé au premier côté, du corps solide (48).

**13.** Dispositif électronique selon l'une quelconque des revendications précédentes, dans lequel la borne de grille (24) est de type bande.

**14.** Procédé de fabrication d'un dispositif électronique (20 ; 30), comprenant les étapes suivantes :

former une borne de grille (24) dans un corps solide (48) ;
former un chemin conducteur (36) configuré pour pouvoir être couplé électriquement à un générateur (23) d'une tension de polarisation ($V_{GS}$) de la borne de grille ;
former un élément de protection (21) en matériau à l'état solide, couplé à la borne de grille (24) et au chemin conducteur (36), l'élément de protection (21) formant une connexion électrique entre la borne de grille (24) et le chemin conducteur (36), et étant configuré pour passer de l'état solide à un état fondu ou gazeux, interrompant ladite connexion électrique, en réponse à un courant de fuite ($i_{SC}$) traversant ledit élément de protection (21) supérieur à seuil critique, **caractérisé en ce qu'**il comprend en outre l'étape consistant à former une cavité enfouie (69) dans le corps solide (48) contenant, au moins en partie, ledit élément de protection (21).

FIG. 1A

FIG. 1B

FIG. 2

FIG. 3

FIG. 4

FIG. 5

FIG. 6A

FIG. 6B

FIG. 6C

FIG. 6D

FIG. 6E

FIG. 7A

FIG. 7B

FIG. 7C

FIG. 7D

FIG. 7E

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20190304907 A1
- US 6252292 B1